# EUROPÄISCHE PATENTSCHRIFT

(11) **EP 1 039 359 B1**
(45) Veröffentlichungstag und Bekanntmachung des Hinweises auf die Patenterteilung: **11.05.2005**
(21) Anmeldenummer: 00105259.6
(22) Anmeldetag: 14.03.2000
(51) Int. Cl.: G05B 23/02, G05B 23/00, G01R 19/165

(54) **Überwachungseinrichtung für elektrische Verbraucher**
Monitoring apparatus for electric consumers
Dispositif de surveillance pour des usagers électriques

(30) Priorität: 25.03.1999 DE 19913471
(43) Veröffentlichungstag der Anmeldung: 27.09.2000
(73) Patentinhaber: ABB PATENT GmbH, 68526 Ladenburg (DE)
(72) Erfinder: Rosch, Rainer, Dr.-Ing., 58513 Lüdenscheid (DE); Zapp, Robert, Dipl.-Ing., 58579 Schalksmühle (DE); Joska, Rolf, Dipl.-Phys.-Ing., 46119 Oberhausen (DE)
(74) Vertreter: Miller, Toivo

(56) Entgegenhaltungen:
- EP-A- 0 858 143
- DE-A- 3 842 921

## Beschreibung

Die Erfindung bezieht sich auf eine Überwachungseinrichtung zur zentralen Erfassung und Meldung des Betriebszustandes und/oder zur Abschaltung einzelner oder mehrerer elektrischer Verbraucher in einem Haushalt gemäß dem Oberbegriff des Anspruches 1. Unter einem Haushalt wird z.B. ein Einfamilienhaus oder eine Wohnung in einem Mehrfachfamilienhaus oder eine sonstige Wohneinheit, z.B. in einem Wohnheim verstanden.

Im Stand der Technik sind vielfältige Einrichtungen zur Sicherheitsabschaltung elektrischer Haushaltsgeräte bekannt. Solche Einrichtungen sind dafür konzipiert, bei einem Defekt am Gerät, bei Überlastsituationen oder als redundante Sicherheitseinrichtung im Fall des Versagens einer ersten Sicherheitseinrichtung eine Abschaltung der Stromzufuhr vorzunehmen. Bekannt sind solche Einrichtungen z. B. bei elektrischen Kaffeemaschinen. Auch für Elektroherde sind unterschiedliche Sicherheitsabschaltmittel bekannt, beispielsweise um bei zu hoher Temperatur oder bei detektierter Rauchentwicklung den Herd abzuschalten.

Aus der EP 0 858 143 A2 ist eine Überwachungseinheit für netzbetriebene Haushaltsgeräte zur Kopplung mit Netzstromzuleitungen bekannt, mit einer Erfassungseinrichtung, die den Netzzuleitungen zugeordnet ist und die Netzparameter, beispielsweise Spannung, Strom, Frequenz oder Impedanz erfasst. In einer Speichervorrichtung sind bestimmte Betriebszustände des Haushaltsgeräts mit den entsprechenden Netzparametern abgelegt. Eine Auswerteeinrichtung liest abhängig von den erfassten Netzparametern den jeweiligen Betriebszustand aus der Speichervorrichtung aus. Es ist ein Lernelement vorgesehen, das in einem Lernmodus zu einem eingebbaren Betriebszustand die momentan erfassten Netzparameter in die Speichervorrichtung einschreibt. In der Speichereinrichtung können die Daten einer Vielzahl von Haushaltsgeräten abgelegt werden.

Es ist möglich, die Auswerteeinrichtung sowie die Speichereinrichtung in eine Überwachungszentrale zu nehmen, wobei der Überwachungseinrichtung in diesem Falle nur noch die Aufgabe zukommt, die Netzparameter zu erfassen und diese erfassten Werte als moduliertes Datensignal an die Überwachungszentrale zu übertragen. Dementsprechend ist aus der EP 0 858 143 A2 ein Überwachungssystem zur Überwachung von netzbetriebenen Haushaltsgeräten bekannt, mit einer dem Haushaltsgerät zugeordneten Überwachungseinrichtung, die eine Erfassungseinrichtung zur Erfassung von Netzparametem und eine Modulationseinrichtung zur Übertragung des von der Erfassungseinrichtung gelieferten Signals als moduliertes Datensignal aufweist. Die Überwachungszentrate weist eine Sende / Empfangseinheit zum Empfang des modulierten Datensignals und eine Steuer- und Ansteuereinrichtung zur Auswertung des übertragenen Datensignals auf.

Aus der DE 38 42 921 A1 ist eine Schaltungsanordnung zur Stromüberwachung elektrischer Verbraucher bekannt, die in ihrer Stromzuführung ein Strommessglied (Strommesswiderstand) aufweisen, dessen stromabhängige Messspannung einer Auswerteschaltung mit einem Mikrorechner zugeführt wird, der Ober Steuerausgänge die Schaltmittel für das Ein- und Ausschalten der zu überwachenden Verbraucher steuert. Zur Überwachung mehrerer Verbraucher sind die ihnen zugeordneten Strommessglieder am Eingang eines Multiplex-Bausteines angeschlossen, dessen Ausgang mit einem Eingang eines gemeinsamen Komparators verbunden ist.

Weitere bekannte Sicherheitseinrichtungen sind Leitungsschutzschalter und Motorschutzschalter, die einen Überstrom oder Kurzschlussstrom erkennen und eine Abschaltung vornehmen.

Der Erfindung liegt dagegen die Aufgabe zugrunde, eine Überwachungseinrichtung zu schaffen, die es ermöglicht, einen versehentlichen oder unerwünschten Betrieb elektrischer Verbraucher eines Haushalts, allgemein einen Betrieb zur falschen Zeit " zu erkennen und zu melden oder zu beenden. Ein solcher versehentlicher Betrieb kann neben einer Energieverschwendung auch eine Gefahrensituation bedeuten. Zu typischen Situationen, in denen eine derartige Überwachungseinrichtung wünschenswert ist, zählen z. B. Urlaub oder sonstige Abwesenheit der Bewohner, wobei ein versehentlicher Betrieb von Beleuchtung, Bügeleisen, Elektroherd, Wärmestrahlern, Heizlüftern usw. erkannt werden und zumindest eine Meldung erfolgen soll. Auch ein unbeaufsichtigter Betrieb von Elektrogeräten während der Nacht kann eine Gefahrensituation bedeuten.

Zur Lösung dieser Aufgabe wird eine Überwachungseinrichtung mit den in Anspruch 1 angegebenen Merkmalen gelöst. Ausführungsvarianten und Ausgestaltungen sind in weiteren Ansprüchen angegeben.

Bei der erfindungsgemäßen Überwachungseinrichtung wird berücksichtigt, dass der Betrieb bestimmter Geräte, wie z. B. von Kühl- und Gefrierschrank und möglicherweise weiterer Geräte gewährleistet sein muss, während situationsbedingt unerwünschter Betrieb weiterer Geräte erfasst werden soll. Die Überwachungseinrichtung ermöglicht eine Anpassung an individuelle und zeitlich wechselnde Überwachungssituationen. Mit einer solchen Einrichtung kann beispielsweise die Sicherheit allein lebender älterer Menschen deutlich erhöht werden.

Eine weitere Beschreibung erfolgt anhand von Ausführungsbeispielen, die in der Zeichnung dargestellt sind.

Es zeigen:
- Fig. 1: eine erste Ausführungsvariante, wobei eine Schwellwertstufe ein Ausgangssignal bildet und über eine Schaltstufe ausgibt,
- Fig.2: eine zweite Ausführungsvariante, bei der anstelle einer Schaltstufe eine Ankoppelschaltung für eine Ausgangssignaleinkopplung in ein Bussystem eines Haussystems vorhanden ist, und
- Fig.3: eine erfindungsgemäße Variante, wobei anstelle einer Schwellwertstufe eine Prüf- und Auswerteinrichtung vorhanden ist, mit der Signalverläufe analysierbar sind und auch Plausibilitätskontrollen ermöglicht sind.

Die dargestellten Beispiele zeigen eine einphasige Einspeisung, im Fall einer dreiphasigen Einspeisung sind zumindest Sensoren je Phasenleitung angeordnet; die übrigen Komponenten der Einrichtung können ebenfalls mehrfach vorhanden sein oder durch zyklische Umschaltung mehrfach genutzt sein.

Besonders vorteilhaft ist eine Integration der Überwachungseinrichtung in ein Hausleitsystem, weil dann auf einfache Weise durch Kombination mit ohnehin vorhandenen Signalen sonstiger Sensoren automatisierte Überwachungseinrichtungs-inteme oder externe Plausibilitätskontrollen oder auch eine Überwachung von Meldungen durch Personen in der Hausleitzentrale möglich sind.

Technisch einfache Überwachungseinrichtungen mit Schwellwertstufen erfordern einen sorgfältigen Abgleich des eingestellten Schwellwertes.

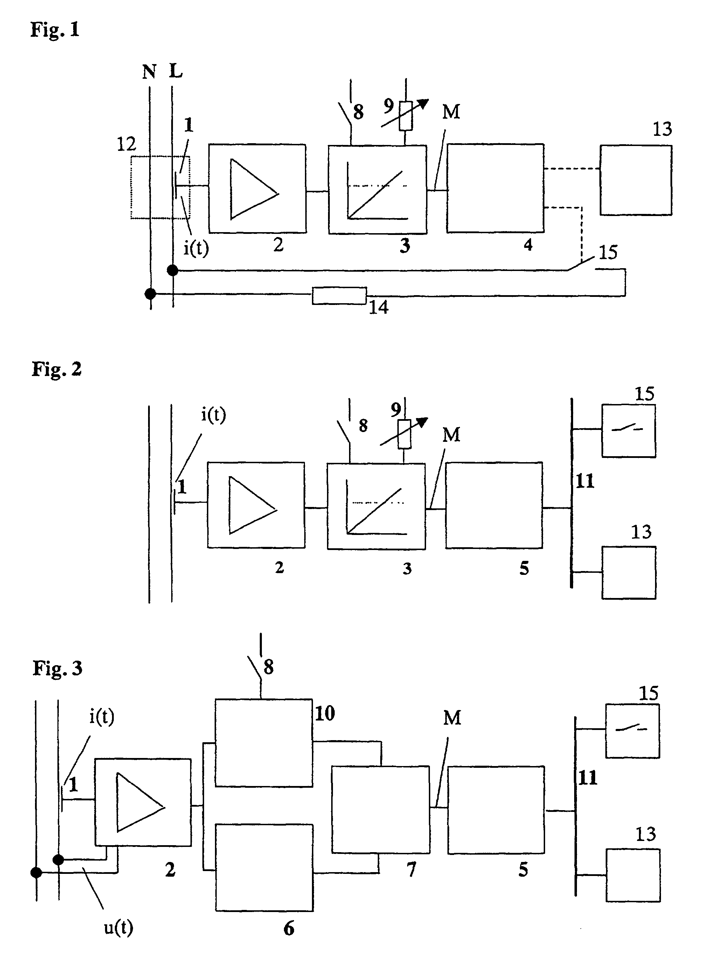

Fig. 1 zeigt ein Blockschema einer Überwachungseinrichtung gemäß einer ersten Ausführungsvariante. Ein Sensor 1 zur Bildung eines stromproportionalen Messsignals i(t) ist am zu überwachenden Phasenleiter L einer Niederspannungsleitung N, L angeordnet. Der Sensor wird ohne Trennung der Stromleitung im Bereich einer Haushalts-Einspeisung 12 eingebaut. Die Strommessung erfolgt magnetisch oder induktiv. Geeignet ist z. B. ein Hall-Element als Sensor 1. Das Messsignal i(t) wird in einer Verstärkerstufe 2 verstärkt und aufbereitet und einer Schwellwertstufe 3 zugeführt. Darin ist ein Stromschwellenwert Iₘₐₓ als Sollwertvorgabe für eine Auslösung einer Meldung gespeichert. Die Sollwertvorgabe ist z. B. mittels eines Potentiometers 9 oder mittels einer Lerntaste 8 einstellbar. Durch einen Druck auf die Lerntaste wird der aktuelle Messwert als Schwellenwert ermittelt und als Referenzwert gespeichert.

Der Schwellwertstufe 3 kann außerdem ein Freigabesignal F zuführbar sein, das beispielsweise während der Nacht oder beim Verlassen der Wohneinheit eingeschaltet wird und das die Ausgabe eines Meldesignals freigibt. Der Schwellwertstufe 3 ist eine Auswertestufe mit Ausgangs- Schaltstufe 4 nachgeschaltet. Mittels eines potentialfreien Kontakts und/oder eines Ausgangssignals kann ein Info-Licht oder eine Anzeige 13 und/oder eine Abschaltung eines Schalters 15 erfolgen, der die Stromzufuhr zu einem elektrischen Verbraucher 14 unterbricht.

Fig. 2 zeigt eine zweite Ausführungsvariante, die sich von der Fig.1 gezeigten Anordnung dadurch unterscheidet, dass anstelle einer Schaltstufe 4 eine Ankoppelschaltung 5 vorhanden ist, mit der bei Überschreitung des eingestellten Schwellenwertes I ₘₐₓ ein Meldetelegramm in ein Bussystem 11 mit beliebigem Übertragungsmedium (TP, PL, RF, IR) eines Hausleitsystems eingebbar ist und das für unterschiedliche Reaktionen, auch zur Verknüpfung mit anderen Informationen nutzbar ist.

Fig. 3 zeigt eine erfindungsgemäße Ausführungsvariante, wobei anstelle der Schwellwertstufe 3 eine Prüf- und Auswerteinrichtung angeordnet ist, die aufweißt:
a) einen Referenzsignalspeicher 10 mit einem gespeicherten Referenzverlauf für einen Vergleich mit dem jeweils aktuellen strom- und spannungsproportionalen Messsignal,
b) eine Vergleicherstufe 6, insbesondere einen Korrelator, womit der Vergleich zwischen Referenzverlauf und Messsignal durchgeführt wird und der Phasenwinkel zwischen Strom- und Spannungsverlauf ermittelt wird, und ein Ähnlichkeitswert ausgegeben wird,
c) eine Auswertestufe 7, der der Ähnlichkeitswert und Zusatzinformation, wie Empfindlichkeitsvorgabe oder vorzunehmende Verknüpfung mit weiteren Eingangssignalen, insbesondere Abwesenheitsmeldung zugeführt sind, und die Plausibilitätskontrollen durchgeführt.

Mit einer solchen Einrichtung kann durch Vergleich mit gespeicherten Signalformen unter anderem erkannt werden, welcher spezifische elektrische Verbraucher fälschlicherweise eingeschaltet ist und eine gezielte Abschaltung veranlasst werden. Die Anordnung ist mittels einer Ankoppelschaltung 5 mit dem Bussystem 11 eines Hausleitsystems verbunden. Über diese Verbindung können auch von anderen Stellen des Hausleitsystems, z. B. einem Leitstand aus, Eingriffe in Rückwärtsrichtung in diese Auswerteeinrichtung, z. B. zur Änderung der Ansprechempfindlichkeit vorgenommen werden. Eine Verknüpfung mit Signalen an anderer Stelle des Hausleitsystems vorgenommen werden.

## Patentansprüche

1. Überwachungseinrichtung zur zentralen Erfassung und Meldung des Betriebszustandes und zur Abschaltung einzelner oder mehrerer elektrischer Verbraucher (14) in einem Haushalt mit einem über ein Bussystem (11) betriebenen Hausleitsystem, wobei vorhanden sind:
a) ein Sensor (1) zur Bildung eines stromproportionalen Messsignals (i(t)),
b) eine Prüf- und Auswerteeinrichtung (6, 7, 10) zur Ermittlung einer als Fehlerzustand definierten Einschaltsituation eines elektrischen Verbrauchers (14), der das stromproportionale Messsignal (i(t)) und ein netzspannungsproportionales Messignal (u(t)) zugeführt sind und die aufweist:
b1) einen Referenzsignalspeicher (10) mit einem gespeicherten Referenzverlauf für einen Vergleich mit den jeweils aktuellen strom- und netzspannungsproportionalen Messsignalen (i(t), u(t)),
b2) eine Vergleicherstufe (6), insbesondere einen Korrelator, womit der Vergleich zwischen Referenzverlauf und Messsignalen (i(t), u(t)) durchgeführt, der Phasenwinkel zwischen Strom- und Spannungsverlauf ermittelt und ein Ähnlichkeitswert ausgegeben wird,
b3) eine Auswertestufe (7), der der Ähnlichkeitswert und Zusatzinformationen, wie beispielsweise eine Empfindlichkeitsvorgabe zugeführt sind,
c) eine Ankoppelschaltung (5), der ein Meldesignal (M) der Auswertestufe (7) zugeführt ist und die eine Fehlermeldung mittels eines entsprechenden Datentelegramms in das Bussystem (11) des Hausleitsystems einspeist, um eine Abschaltung des betroffenen elektrischen Verbrauchers (14) zu veranlassen,
**dadurch gekennzeichnet**,
d) dass der Sensor (1) zur Erfassung des Haushalt-bezogenen Netzstromes und zur Bildung des stromproportionalen Messsignals (i(t)) am zu überwachenden Phasenleiter (L) einer Niederspannungsleitung (N, L) angeordnet und ohne Trennung der Stromleitung im Bereich der Haushalts-Einspeisung (12) im elektromagnetischen Feld des jeweiligen zu überwachenden Phasenleiters eingebaut und nicht vom Netzstrom durchflossen ist und
e) dass der Auswertestufe (7) ohnehin vorhandene Signale sonstiger Sensoren des Hausleitsystems, insbesondere Abwesenheitsmeldungen, zuführbar sind und dass die Auswertestufe (7) automatisierte Überwachungseinrichtungs-inteme oder -externe Plausibilitätskontrollen durchführt.

2. Überwachungseinrichtung nach Anspruch 1, **dadurch gekennzeichnet, dass** dem Sensor (1) eine Verstärkerstufe (2) zur Signalverstärkung und -aufbereitung nachgeschaltet ist.

3. Überwachungseinrichtung nach Anspruch 1, **dadurch gekennzeichnet, dass** der Referenzsignalspeicher (10) dafür eingerichtet ist, einen zwischen einer ersten und einer zweiten darauffolgenden Betätigung einer Lerntaste (8) erfassten Verlauf der strom- und netzspannungsproportionalen Messsignale (i(t), u(t)) als Referenzverlauf zu speichern.

4. Überwachungseinrichtung nach einem der vorstehenden Ansprüche, **dadurch gekennzeichnet, dass** als Sensor (1) ein Hall-Element eingesetzt ist, das am zu überwachenden Leiter angebracht ist.

5. Überwachungseinrichtung nach einem der vorstehenden Ansprüche, **dadurch gekennzeichnet, dass** im Fall eines 3-phasigen Haushaltsanschlusses Mittel (1 bis 10) zur Überwachung aller Phasenströme angeordnet sind.

## Claims

1. A monitoring device for the central detection and reporting of the operational state and for cutting off individual or several electric consumers (14) in a household with a building automation control center operated via a bus system (11), with the following being present:
a) a sensor (1) for forming a current-proportional measuring signal (i(t));
b) a testing and evaluating device (6, 7, 10) for determining an activation situation of an electric consumer defined as an error state and to which the current-proportional measuring signal (i(t)) and a mains-voltage-proportional measuring signal (u(t)) are supplied and which comprises:
b1) a reference signal memory (10) with a stored reference curve for a comparison with the respectively current current- and mains-voltage-proportional measuring signals (i(t), u(t));
b2) a comparator module (6), especially a correlator, with which the comparison between the reference curve and the measuring signals (i(t), u(t)) is performed, the phase angle between current and voltage curve is determined and a similarity value is issued;
b3) an evaluating module (7) to which the similarity value and additional information such as a default sensitivity value are supplied;
c) a coupling circuit (5) to which a signaling signal (M) of the evaluating module (7) is supplied and which supplies an error message by means of a respective data message to the bus system (11) of the building automation control system in order to initiate a cut-off of the affected electric consumer (14),
**characterized in that**
d) the sensor (1) for detecting the household-related mains current and for forming the current-proportional measuring signal (i(t)) is arranged on phase conductor (L) of a low-voltage conductor (N, L) to be monitored and without separation of the current conductor is built into the magnetic field of the phase conductor to be monitored in the region of the household supply (12) and is not flowed through by mains current, and
e) the evaluating module (7) can be supplied with signals of other sensors of the building automation control system which are present anyway, especially absence messages, and that the evaluating module (7) performs automated monitoring-device-internal or -external plausibility checks.

2. A monitoring device according to claim 1, **characterized in that** the sensor (1) is provided in outgoing circuit with an amplifier module (2) for signal amplification and conditioning.

3. A monitoring device according to claim 1, **characterized in that** the reference signal memory (10) is configured to store the curve of the current- and mains-voltage-proportional measuring signals (i(t), u(t)) as a reference curve which is detected between a first and second subsequent actuation of a learning button (8).

4. A monitoring device according to one of the preceding claims, **characterized in that** a Hall element is used as a sensor (1) which is attached to the conductor to be monitored.

5. A monitoring device according to one of the preceding claims, **characterized in that** means (1 to 10) are provided for monitoring all phase currents in the case of a three-phase household connection.

## Revendications

1. Installation de surveillance pour la détection et la signalisation centralisées de l'état de fonctionnement et de l'arrêt de certains ou plusieurs consommateurs électriques (14) dans une maison avec un système de commande domotique fonctionnant par un système de bus (11), laquelle comprend :
a) un capteur (1) destiné à générer un signal de mesure (i(t)) proportionnel à l'intensité,
b) une installation de contrôle et d'interprétation (6, 7, 10) destinée à déterminer une situation d'activation d'un consommateur électrique (14) définie comme un état d'erreur, qui reçoit le signal de mesure proportionnel à l'intensité (i(t)) et un signal de mesure proportionnel à la tension du réseau (u(t)), et qui comprend :
b1) une mémoire de signaux de référence (10) avec une courbe de référence mémorisée pour la comparaison avec les signaux de mesure proportionnels à l'intensité et à la tension du réseau (i(t), u(t)) actuels,
b2) un étage de comparateur (6), en particulier un corrélateur, qui réalise la comparaison entre la courbe de référence et les signaux de mesure (i(t), u(t)), détermine l'angle de phase entre les courbes d'intensité et de tension et produit une valeur de similitude,
b3) un étage d'interprétation (7) qui reçoit la valeur de similitude et des informations complémentaires, par exemple une consigne de sensibilité,
c) un circuit de couplage (5) qui reçoit un signal de notification (M) de l'étage d'interprétation (7) et transmet un message d'erreur au système de bus (11) du système de commande domotique au moyen d'un télégramme de données correspondant, pour faire arrêter le consommateur électrique concerné (14),
**caractérisée en ce que**
d) le capteur (1) pour la détection du courant de réseau de la maison et pour la génération du signal de mesure proportionnel à l'intensité (i(t)) est disposé sur le conducteur de phase (L) à surveiller d'une ligne basse tension (N, L) et intégré sans coupure de la conduction électrique au niveau de l'alimentation domestique (12) dans le champ électromagnétique du conducteur de phase à surveiller et n'est pas parcouru par le courant du réseau, et
e) **en ce que** l'étage d'interprétation (7) peut recevoir les signaux présents d'autres capteurs du système de commande domotique, en particulier des messages d'absence, et l'étage d'interprétation (7) exécute des contrôles de plausibilité internes ou externes à l'installation de surveillance.

2. Installation de surveillance selon la revendication 1, **caractérisée en ce qu'**un étage d'amplificateur (2) destiné à amplifier et préparer les signaux est monté en aval du capteur (1).

3. Installation de surveillance selon la revendication 1, **caractérisée en ce que** la mémoire de signaux de référence (10) est conçue pour mémoriser une courbe des signaux de mesures proportionnels à l'intensité et à la tension du réseau (i(t), u(t)) recueillie entre un premier actionnement d'un bouton d'apprentissage (8) et un deuxième actionnement de celui-ci pour servir de courbe de référence.

4. Installation de surveillance selon l'une quelconque des revendications précédentes, **caractérisée en ce que** le capteur (1) utilisé est un élément à effet Hall monté sur le conducteur à surveiller.

5. Installation de surveillance selon l'une quelconque des revendications précédentes, **caractérisée en ce que** dans le cas d'une connexion domestique triphasée, des moyens (1 à 10) sont prévus pour surveiller tous les courants de phase.
